# EUROPEAN PATENT APPLICATION

(11) **EP 4 811 998 A1**
(43) Date of publication of application: **23.09.2026**
(21) Application number: 26161589.2
(22) Date of filing: 02.03.2026
(51) Int. Cl.: H10P 50/66, H10P 50/68

(54) **ETCHING METHOD**

(30) Priority: 17.03.2025 JP 2025042030
(71) Applicant: SCREEN Holdings Co., Ltd., Kyoto-shi, Kyoto 602-8585 (JP)
(72) Inventor: TAKEMATSU, Yusuke, Kyoto, 602-8585 (JP); HARA, Keisuke, Kyoto, 602-8585 (JP); SATO, Masanobu, Kyoto, 602-8585 (JP); FUJIWARA, Naozumi, Kyoto, 602-8585 (JP); UEDA, Takumi, Kyoto, 602-8585 (JP); YAMAMURA, Mioto, Kyoto, 602-8585 (JP); LI, Mingjhe, Kyoto, 602-8585 (JP); OKAMOTO, Koichi, Kyoto, 602-8585 (JP); MAKI, Yusuke, Kyoto, 602-8585 (JP); SHIRAO, Takashi, 300070 Hsinchu (TW); OSUKA, Tsutomu, Kyoto, 602-8585 (JP); NISHIDE, Hajime, Kyoto, 602-8585 (JP); KIBI, Kazuo, Kyoto, 602-8585 (JP)
(74) Representative: Kilian Kilian & Partner mbB

(57) **Abstract**

In an etching method in accordance with the present invention, ultraviolet rays are irradiated to an etching solution. As a result, OH radicals are generated in the etching solution. Then, etching of a to-be-etched film is performed by the etching solution containing the OH radicals. Accordingly, it becomes possible to efficiently etch the to-be-etched film by using an etching solution on a substrate on which the to-be-etched film is formed to be adjacent to an insulating film.

## Description

### CROSS REFERENCE TO RELATED APPLICATION

The disclosure of Japanese Patent Application No. 2025-42030 filed on March 17, 2025 including specification, drawings and claims is incorporated herein by reference in its entirety.

### BACKGROUND OF THE INVENTION

### 1. Field of the Invention

This invention relates to an improvement of wet etching.

### 2. Description of the Related Art

In a manufacturing field of semiconductor devices, the wet etching technique is one of important techniques, as well as the photolithography technique. The present applicant has studied on various wet etching techniques dealing with higher density and larger capacity of a semiconductor device (JP 2021-153077A, JP 2021-48369A, JP 2022-149413A, and JP 2023-123997A). In these background arts, etching of a to-be-etched film is performed by immersing a substrate into an etching solution containing an etchant used for etching the to-be-etched film.

### SUMMARY OF THE INVENTION

In the above-described wet etching technique, the etchant is present in an ionic state in the etching solution, and therefore it has sometimes been impossible to approach the film to be etched, resulting in failure to obtain a desired etching rate.

This invention is intended to solve the above problem, and it is an object of the present invention to provide an etching method for efficiently etching a to-be-etched film by using an etching solution on a substrate on which the to-be-etched film is formed to be adjacent to an insulating film.

The invention is directed to an etching method. The method includes selectively etching a to-be-etched film by using an etching solution on a substrate on which the to-be-etched film is formed to be adjacent to an insulating film, wherein the etching solution contains OH radical generated by irradiating the etching solution with ultraviolet rays.

In an interface where the to-be-etched film and the insulating film are in contact with each other, an electric double layer is formed. For this reason, in the related art in which the etchant contained in the etching solution is in the ionic state, there is a problem that the etchant is difficult to approach the to-be-etched film due to coulomb repulsion and an expected etching rate cannot be obtained. In contrast to this, since OH radical generated by irradiating the etching solution with ultraviolet rays is electrically neutral and hard to be affected by the electric double layer, it becomes possible to increase the etching rate by using this OH radical as the etchant.

Thus, according to the present invention, the electrically neutral OH radical is generated in the etching solution and this functions as the etchant of the to-be-etched film. For this reason, it becomes possible to efficiently etch the to-be-etched film on the substrate which is difficult to be etched with a sufficient etching rate by using the etching solution containing only the etchant in the ionic state.

All of a plurality of constituent elements of each aspect of the present invention described above are not essential and some of the plurality of constituent elements can be appropriately changed, deleted, replaced by other new constituent elements or have limited contents partially deleted in order to solve some or all of the aforementioned problems or to achieve some or all of effects described in this specification. Further, some or all of technical features included in one aspect of the present invention described above can be combined with some or all of technical features included in another aspect of the present invention described above to obtain one independent form of the present invention in order to solve some or all of the aforementioned problems or to achieve some or all of the effects described in this specification.

### BRIEF DESCRIPTION OF THE DRAWINGS

FIG. 1 is a view schematically showing an effect produced on a narrow space etching process by an electric double layer;
FIG. 2 is a schematic view showing a first embodiment of an etching method in accordance with the present invention;
FIG. 3 is a schematic view showing a second embodiment of the etching method in accordance with the present invention;
FIG. 4 is a schematic view showing a third embodiment of the etching method in accordance with the present invention;
FIG. 5 is a view showing an overview of an oxidation-reduction reaction occurring in the third embodiment and an oxidation-reduction potential;
FIG. 6 is a schematic view showing a fourth embodiment of the etching method in accordance with the present invention;
FIG. 7 is a schematic view showing a fifth embodiment of the etching method in accordance with the present invention;
FIG. 8 is a view showing part of a substrate prepared to verify a narrow space etching using the first to third embodiments;
FIG. 9 is a view showing an overview of a verification experiment for the first and second embodiments;
FIG. 10 is a view schematically showing respective etching results obtained by performing etching processes of Comparative Example 1 and Example 1 on the substrate shown in FIG. 8;
FIG. 11 is a view showing an overview of a verification experiment for the third embodiment;
FIG. 12 is a view schematically showing respective etching results obtained by performing etching processes of Comparative Example 2 and Examples 2, 3, and 4 on the substrate shown in FIG. 8;
FIG. 13 is a view schematically showing respective etching results obtained by performing etching processes of Comparative Example 3 and Example 5 on the substrate shown in FIG. 8; and
FIG. 14 is a view schematically showing respective etching results obtained by performing etching processes of Comparative Example 4 and Examples 6 and 7 on the substrate shown in FIG. 8.

### DETAILED DESCRIPTION OF THE PREFERRED EMBODIMENTS

### A. Wet Etching using OH Radical

### A-1. Analysis on Conventional Wet Etching Based on Model

As is conventionally well known, an electric double layer is formed at the interface where a to-be-etched film comes into contact with an etching solution. In a narrow space etching process shown in JP 2021-153077A, for example, the electric double layer significantly affects an etching rate. The narrow space etching process refers to a process in which by supplying an etching solution to a substrate in which a multilayer structure formed of repeatedly layered two types of thin films having different compositions is formed on a base material such as silicon, only a thin film (which corresponds to one example of a "to-be-etched film" of the present invention) on one side is etched.

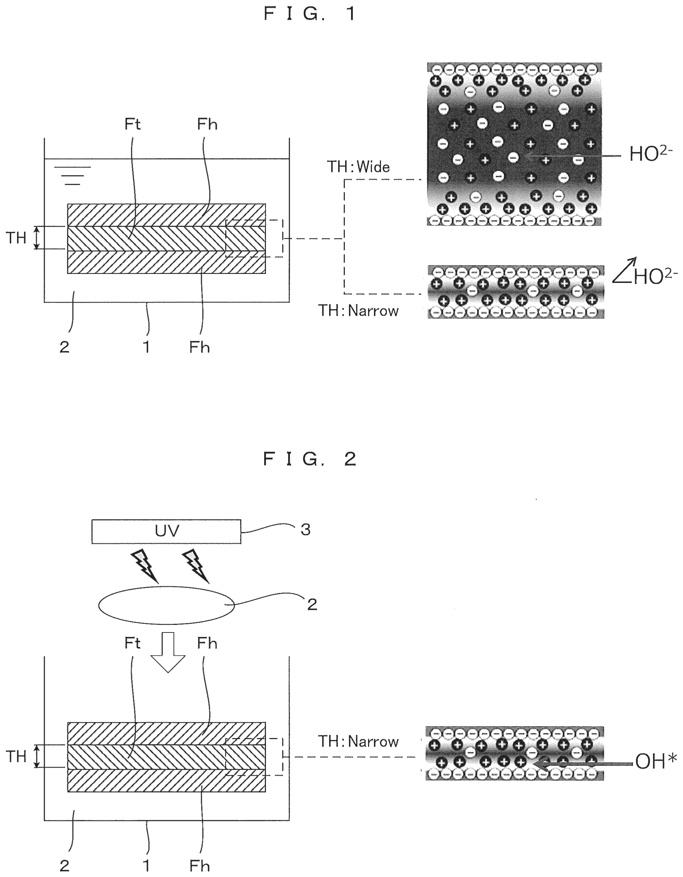

FIG. 1 is a view schematically showing an effect produced on the narrow space etching process by the electric double layer. In this figure, shown is extracted part of the multilayer structure on the substrate. Herein, a TiN film Ft as one example of the to-be-etched film is sandwiched by HfO₂ films Fh as one example of high-k dielectrics, serving as insulating films. In other words, the HfO₂ film Fh is layered on an upper surface and a lower surface of the TiN film Ft. When the substrate having such a multilayer structure is immersed into an etching solution 2, e.g., SC1 (Standard Clean 1), stored in a processing bath 1, at an etching early stage, the etching solution 2 comes into contact with an exposed portion of the TiN film Ft, i.e., a side surface thereof, to thereby perform etching removal. Subsequently to this, the above-described etching proceeds along the TiN film Ft, in other words, in a direction orthogonal to a layer direction of the thin films. At that time, an etching behavior of the TiN film Ft is sometimes different in accordance with the film thickness TH of the TiN film Ft.

The electric double layer is formed in an interface between the upper surface of the TiN film Ft and a lower surface of the HfO₂ film Fh adjacent thereto and the electric double layer is also formed in an interface between the lower surface of the TiN film Ft and an upper surface of the HfO₂ film Fh adjacent thereto. An interval between these electric double layers is proportional to the film thickness TH of the TiN film Ft. In other words, when the film thickness TH is relatively thick, the interval of the electric double layers is wide as shown in the upper-right view of this figure, and an etchant (OH²⁻ in this figure) electrically charged with a negative potential is easy to approach the side surface of the TiN film Ft and the above-described etching proceeds in the direction orthogonal to the layer direction of the thin films. In contrast to this, as the film thickness TH becomes thinner, the interval of the electric double layers becomes narrower as shown in the lower-right view of this figure, and the etchant becomes harder to approach the TiN film Ft due to coulomb repulsion. As a result, the etching rate is significantly reduced. As indicated in the later experimental result, even when the film thickness TH of the TiN film Ft is 10 nm, actually, sufficient etching rate cannot be obtained.

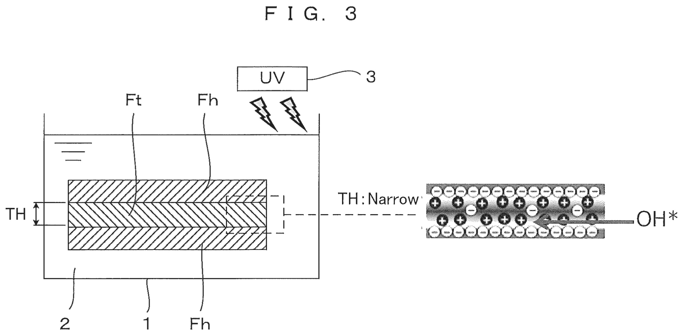

In contrast to this, as show in FIGs. 2 and 3, for example, by using OH radical (hydroxyl radical) generated by irradiating the etching solution with ultraviolet rays, as the etchant, it becomes possible to increase the etching rate.

FIG. 2 is a schematic view showing the first embodiment of the etching method in accordance with the present invention. In the first embodiment, the substrate having the above-described multilayer structure (only the multilayer structure is shown in this figure) is accommodated into the processing bath 1. On the other hand, an ultraviolet ray generator 3 irradiates the etching solution 2 with the ultraviolet rays in advance to generate the OH radical in the etching solution 2, and then the etching solution 2 containing the OH radical is supplied to the substrate accommodated in the processing bath 1. Thus, in the processing bath 1, the substrate is immersed in the etching solution 2 . The OH radical is electrically neutral. For this reason, without being affected by the electric double layers, not only at the etching early stage, but also during the narrow space etching after a small opening having the same size as the film thickness TH is formed in the side surface of the TiN film Ft by this etching process, the OH radical approaches the side surface of the TiN film Ft to cause the etching to proceed. It thereby becomes possible to cause the above-described etching to deeply proceed along the TiN film Ft, i.e., in the direction orthogonal to the layer direction (the up-and-down direction in this figure) of the TiN film Ft and the HfO₂ film, to thereby form a recessed portion having a desired elongated size. In other words, it is possible to efficiently etch the thin film-like TiN film Ft sandwiched between the HfO₂ films. Further, the action and effect of the first embodiment will be described in detail through the later-described Examples.

FIG. 3 is a schematic view showing the second embodiment of the etching method in accordance with the present invention. The second embodiment is largely different from the first embodiment in the irradiation timing of the ultraviolet rays. Specifically, in the second embodiment, in the state where the substrate is immersed in the etching solution 2 stored in the processing bath 1, the ultraviolet ray generator 3 irradiates the etching solution 2 with the ultraviolet rays from above the processing bath 1, to thereby generate the OH radical in the etching solution 2. Like in the first embodiment, without being affected by the electric double layers, the OH radical thereby approaches the side surface of the TiN film Ft to cause the etching to proceed. As a result, like in the first embodiment, it is possible to efficiently etch the thin film-like TiN film Ft sandwiched between the HfO₂ films. Further, the action and effect of the second embodiment will be also described in detail through the later-described Examples.

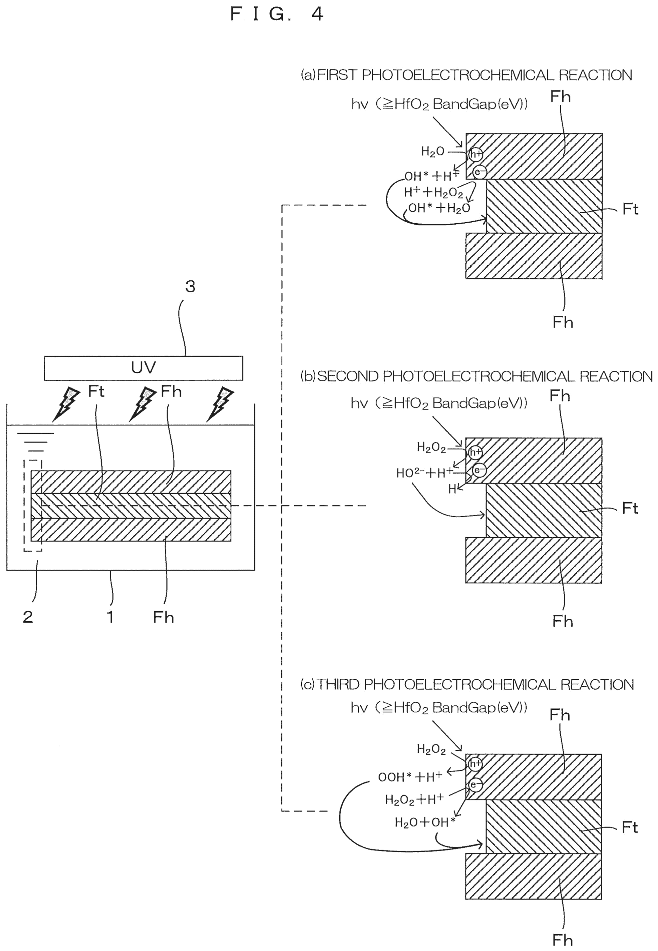

Though only the etching solution 2 in the processing bath 1 is irradiated with the ultraviolet rays in the above-described second embodiment, the ultraviolet rays may be emitted toward the substrate immersed in the etching solution, as shown in FIG. 4 (the third embodiment).

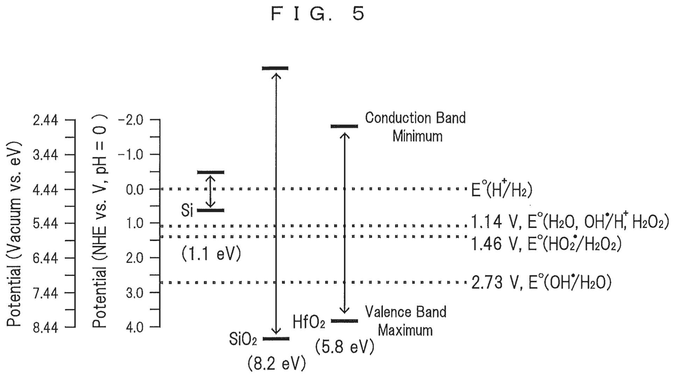

FIG. 4 is a schematic view showing the third embodiment of the etching method in accordance with the present invention. FIG. 5 is a view showing an overview of an oxidation-reduction reaction occurring in the third embodiment and an oxidation-reduction potential. In the third embodiment, the ultraviolet rays from the ultraviolet ray generator 3 are irradiated not only to the etching solution but also to the multilayer structure. Herein, when certain conditions are satisfied, besides the etchant generated by ultraviolet irradiation to the etching solution, i.e., the OH radical, another etchant caused by a photoelectrochemical reaction on the HfO₂ film irradiated with the ultraviolet rays is additionally generated. By using, for example, an SC1 solution as the etching solution and performing irradiation of ultraviolet rays having a frequency v to satisfy the following inequality;
Energy of ultraviolet rays E = hv ≥ (bandgap of HfO₂), where h represents a Planck constant,
three types of oxidation-reduction reactions as shown in the right-side views in FIG. 4 occur, to thereby generate above-described another etchant. In more detail, the first oxidation-reduction reaction is a reaction shown in the upper-right stage in FIG. 4, and the oxidation-reduction potential (redox potential) therein is 1.14 Vvs.NHE as shown in FIG. 5 (see P. Pichat., Photocatalysis and Water Purification, First Edition, 1.1, 5, 2013). Further, NHE stands for normal hydrogen electrode. By the first oxidation-reduction reaction, OH radical is generated as the etchant of the TiN film Ft in the vicinity of the HfO₂ film Fh irradiated with the ultraviolet rays.

The second oxidation-reduction reaction is a reaction shown in the middle-right stage in FIG. 4, and the oxidation-reduction potential therein is 1.46 Vvs.NHE as shown in FIG. 5 (see Fuentes, J.P., et al., Photochem Photobiol Sci 22, 1855-1864 (2023)). By the second oxidation-reduction reaction, HO²⁻ is generated as the etchant of the TiN film Ft in the vicinity of the HfO₂ film Fh irradiated with the ultraviolet rays.

The third oxidation-reduction reaction is a reaction shown in the lower-right stage in FIG. 4, and the oxidation-reduction potential therein is 2.73 Vvs.NHE as shown in FIG. 5 (see Fuentes, J.P., et al., Photochem Photobiol Sci 22, 1855-1864 (2023)). By the third oxidation-reduction reaction, OOH radical and OH radical are generated as the etchant of the TiN film Ft in the vicinity of the HfO₂ film Fh irradiated with the ultraviolet rays.

Thus, according to the third embodiment, the etchant concentration becomes higher than that in the second embodiment, and it is possible to more efficiently etch the TiN film Ft. Further, the action and effect of the third embodiment will be also described in detail through the later-described Examples.

Furthermore, the irradiation mode of the ultraviolet rays in the above-described first embodiment (FIG. 2) and the irradiation mode of the ultraviolet rays in the third embodiment (FIG. 4) may be combined with each other (the fourth embodiment).

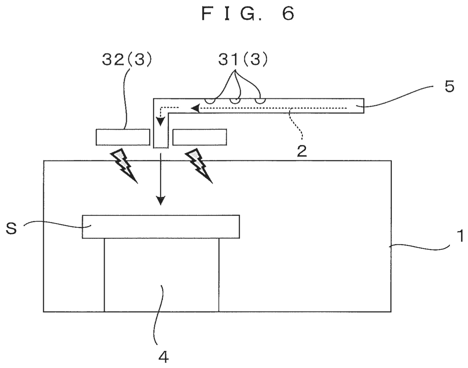

FIG. 6 is a schematic view showing the fourth embodiment of the etching method in accordance with the present invention. In the fourth embodiment, as shown in this figure, a substrate S having the above-described multilayer structure is placed on an upper surface of a support mount 4 set on an inner bottom of the processing bath 1. Outside the processing bath 1, disposed is an arm-like supply member 5 so that a supply port provided at a tip thereof can face the substrate S supported by support mount 4 inside the processing bath 1. In the supply member 5, a pipe (not shown) for feeding the etching solution 2 toward the supply port is provided and an ultraviolet ray generator 31 (which corresponds to the ultraviolet ray generator 3 of the first embodiment) for irradiating the ultraviolet rays to the etching solution 2 flowing in the pipe is attached. For this reason, the OH radical is generated in the etching solution 2 irradiated with the ultraviolet rays, during flowing in the above-described pipe. Then, like in the first embodiment, the etching solution 2 containing the OH radical is supplied to the substrate S accommodated in the processing bath 1.

Further, an ultraviolet ray generator 32 (which corresponds to the ultraviolet ray generator 3 of the third embodiment) having an annular shape in a plan view from above is so disposed as to surround the supply port from a horizontal direction. For this reason, when the ultraviolet rays are irradiated from the ultraviolet ray generator 32 to the substrate S accommodated in the processing bath 1 and supplied with the etching solution 2 containing the OH radical from the supply member 5, like in the third embodiment, another etchant is additionally generated in the etching solution 2 by the photoelectrochemical reaction.

Thus, according to the fourth embodiment, the etching solution 2 not only contains the OH radical as the etchant like in the first to third embodiments but also contains etchants more than that in each of the first to third embodiments. As a result, it is possible to etch the TiN film with the etching rate higher than that in each of the first to third embodiments.

Further, the so-called narrow space etching process in which the substrate on which the HfO₂ film Fh as one example of the "insulating film" is layered on the upper surface and the lower surface of the TiN film Ft as one example of the "to-be-etched film" is selectively etched from the side surface side of the TiN film Ft in the first to fourth embodiments. By contrast, the first to fourth embodiments are also applied to a substrate having a multilayer structure in which the TiN film Ft is layered only on one main surface of the HfO₂ film Fh, and it is thereby possible to excellently etch the TiN film (the fifth embodiment).

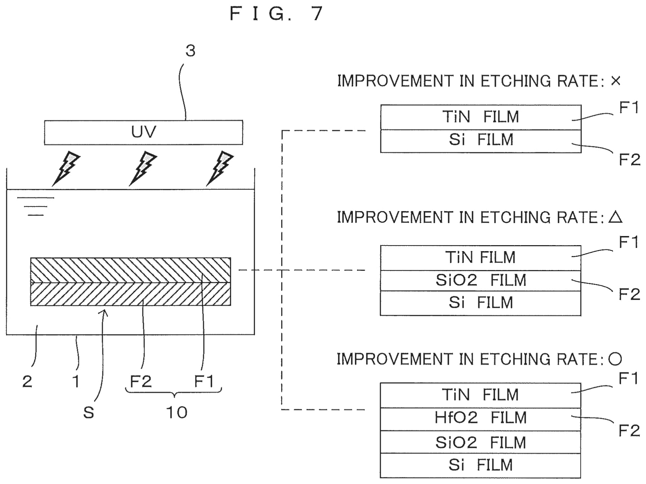

FIG. 7 is a schematic view showing the fifth embodiment of the etching method in accordance with the present invention. In the fifth embodiment, as shown in this figure, like in the third embodiment, a substrate S having a multilayer structure 10 in which a first film F1 which corresponds to the to-be-etched film is formed adjacent to a second film F2 is immersed in the etching solution 2 stored in the processing bath 1. Then, the multilayer structure 10 of the substrate S, as well as the etching solution 2, is also irradiated with the ultraviolet rays from the ultraviolet ray generator 3.

Herein, in an experiment where the first film F1 is etched with the OH radical generated by ultraviolet irradiation to the etching solution 2 and the etchant generated by the photoelectrochemical reaction, obtained is a result shown on the right side of this figure. Even when the first film is the to-be-etched film formed of the TiN film, like in the first to fourth embodiments, for example, depending on the film type of the second film F2 adjacent to the TiN film, it is not recognized, in some cases, that the etching rate becomes higher. In a case where the second film F2 is a silicon film, as shown in the upper-right stage in this figure, for example, it is not recognized that the etching rate becomes higher. On the other hand, in a case where the second film F2 is a SiO₂ film or a HfO₂ film, it is recognized that the etching rate becomes higher but the degree of increase is different.

It is considered that such a variation is caused by the difference of the bandgap, as shown in FIG. 5, depending on the film type of the second film (insulating film) F2. Specifically, in the case where the second film F2 is a semiconductor such as silicon or the like, the bandgap is narrow and the requirements to cause the photoelectrochemical reaction (hereinafter, referred to as "photoelectrochemical requirements") are not inherently satisfied. On the other hand, in the case where the second film F2 is an insulator such as SiO₂, HfO₂, or the like, the photoelectrochemical requirements are satisfied. Moreover, as shown in FIGs. 4 and 5, the oxidation-reduction reaction relating to the etchant generation is present in the bandgap. For this reason, the etching rate is increased by additional generation of the etchant.

Herein, there arises a difference in the increase in the etching rate between SiO₂ and HfO₂, and this can be analyzed below. Specifically, in comparison between the respective bandgaps of SiO₂ and HfO₂, both bandgaps include the oxidation-reduction reaction order contributing to TiN etching. The bandgap of HfO₂ is, however, narrower than that of SiO₂, and the required light energy for UV irradiation therein is less. As a result, it is analyzed that, in terms of etchant ionization efficiency due to the photoelectric effect, HfO₂ is higher than SiO₂ and this causes the difference in the degree of etching therebetween.

Further, the present invention is not limited to the above-described embodiments, but numerous modifications and variations other than those described above can be devised without departing from the scope of the invention. For example, though SC1 is used as an "etching solution" of the present invention and the TiN film Ft and the HfO₂ film Fh are respective examples of a "to-be-etched film" and an "insulating film" of the present invention in the above-described first to third embodiments, the combination of the "etching solution", the "to-be-etched film", and the "insulating film" is not limited to this one. For example, as the "etching solution", a solution containing one or more types selected from a group consisting of dH₂O₂, SC2 (Standard Clean 2), dHCl, dNH₄OH, dHF, DIW, and CO₂W can be used. Further, as the "to-be-etched film", included is a thin film formed of Al₂O₃, La₂O₃, W, Mo, Ru, WDC (tungsten-doped carbon), or the like. Furthermore, as the "insulating film", included is a thin film formed of SiOₓ, HfOₓ, La₂O₃, TiCAL (titanium carbide aluminum), ZrO, ScOₓ, YO, or the like.

### [Examples]

Hereinafter, the preferred embodiments of the present invention will be described more specifically with reference to Examples. Needless to say, however, the present invention is not limited by the following Examples. Therefore, it is of course possible to make appropriate modifications within the scope of the gist of the above and later descriptions, and all of them are included in the technical scope of the present invention.

### <Substrate used in Verification Experiment of Narrow Space Etching>

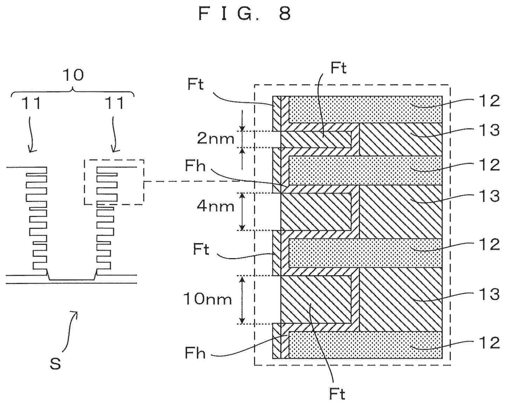

FIG. 8 is a view showing part of a substrate prepared to verify a narrow space etching using the first to third embodiments, and shows a multilayer structure formed on a silicon base material. This multilayer structure 10 is a structure existing in a process of manufacturing a transistor having a Forksheet structure, which is reproduced.

In the multilayer structure 10, two layered bodies 11 are standing in a state of being separated away from each other by a predetermined interval in the horizontal direction. In each layered body 11, a SiO₂ film 12 and a SiN film 13 are alternately layered. In the horizontal direction, the SiN film 13 is shorter than the SiO₂ film 12, and an end portion of the SiN film 13 is retracted deeper than that of the SiO₂ film 12 inside the layered body 11. At each retracted position, a first recessed portion in the horizontal direction is formed of a side surface of the SiN film 13, an upper surface of the SiO₂ film 12 adjacent to a lower surface of the SiN film 13, and a lower surface of the SiO₂ film 12 adjacent to an upper surface of the SiN film 13. The HfO₂ film Fh is so continuously formed as to cover an inner bottom and an inner surface of the first recessed portion and a side surface of the SiO₂ film 12 with a constant film thickness. For this reason, among portions of HfO₂ film Fh, the portion corresponding to the above-described first recessed portion constitutes a second recessed portion having a shape recessed inward of the layered body 11. This second recessed portion has an opening size narrower than that of the first recessed portion in the up-and-down direction. Further, in the layered body 11, the second recessed portion is filled with TiN. By filling the second recessed portion with TiN, TiN is adhered to a side surface region sandwiched between adjacent second recessed portions in the HfO₂ film Fh, i.e., a region facing the end portion of the SiO₂ film 12, to be connected to the TiN filling the second recessed portion, to thereby form the TiN film Ft.

In an actual process of manufacturing the Forksheet transistor, as one process step, there is a step of exposing the second recessed portion covered with the HfO₂ film Fh by etching removal of the TiN film Ft. In other words, by efficient etching removal of the TiN film Ft, it is desirable to remove not only the TiN adhering to the side surface region of the layered body 11 but also the TiN filling the inside of the second recessed portion, i.e., a narrow region.

Then, the above-described first to third embodiments are proposed. In order to verify the etching performance in the first to third embodiments, the substrates for verification are prepared. As shown in the enlarged view of FIG. 8, each substrate has, for the layered body 11, one set of three different narrow space sizes (2 nm, 4 nm, and 10 nm in this embodiment) of the second recessed portion in the vertical direction, i.e., the opening size of the second recessed portion, and thus has a total of three sets, nine second recessed portions for each layered body 11. Then, as described below, verification experiments for the first to third embodiments are performed and respective narrow space etching states of the TiN film Ft in the second recessed portion are measured.

### <Verification Experiments for The First and Second Embodiments>

In the first embodiment, after the etching solution 2 is irradiated with the ultraviolet rays outside the processing bath 1, the etching solution 2 is supplied to the processing bath 1. On the other hand, in the second embodiment, the etching solution 2 which has been supplied to the processing bath 1 is irradiated with the ultraviolet rays. These embodiments are in common in that only the etching solution 2 is irradiated with the ultraviolet rays. Then, the verification experiment for the first and second embodiments is performed as follows.

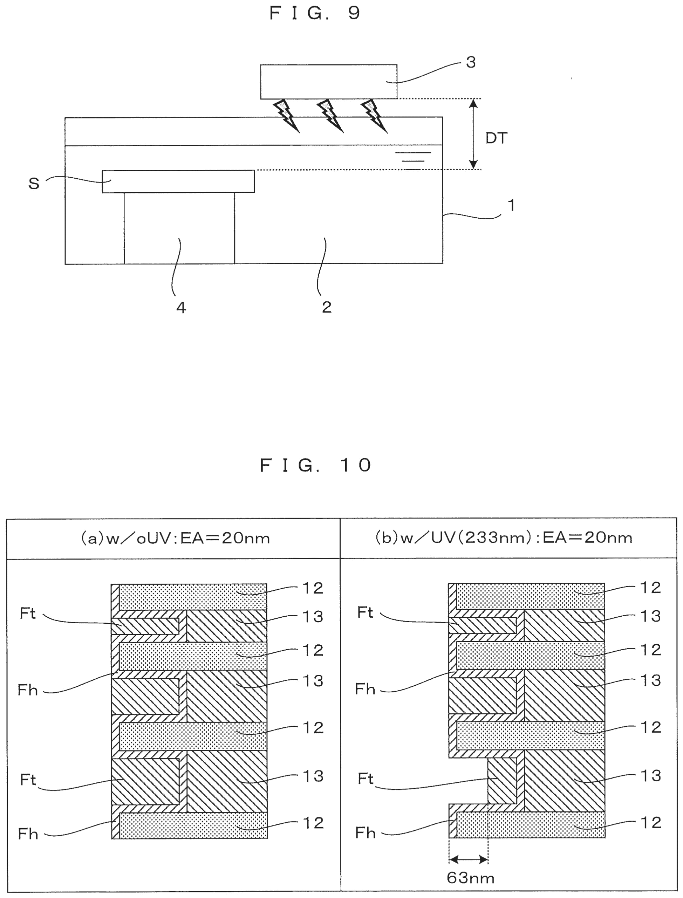

FIG. 9 is a view showing an overview of the verification experiment for the first and second embodiments. In this verification experiment, the substrate S for verification having the above-described multilayer structure 10 is placed on the upper surface of the support mount 4 set on the inner bottom of the processing bath 1. Further, in this verification experiment, wet etching in which the substrate S is immersed in dHF (1:500) for 60 seconds is performed beforehand on the substrate S, to thereby remove a natural oxide film formed on a surface of the substrate S. The same applies to other Comparative Examples and Examples in this point. In this verification experiment, the substrate S for verification having the above-described multilayer structure 10 is placed on the upper surface of the support mount 4 set on the inner bottom of the processing bath 1 and immersed in the etching solution 2 stored in the processing bath 1. Then, the ultraviolet rays are irradiated only to the etching solution 2 from the ultraviolet ray generator 3 while emission of the ultraviolet rays to the substrate S is regulated. After that, an etching result is verified. Note that, in Comparative Example 1 and Example 1, the type of the etching solution 2 which is used, Blanket EA (hereinafter, referred to simply as "EA"), the surrounding conditions of the verification experiment, the wavelength of the ultraviolet ray, whether ultraviolet irradiation is performed or not, and the distance Dt between the substrate and the ultraviolet ray generator 3 in the up-and-down direction are as follows. Herein, "EA = T nm" means that the etching process is performed on the substrate S for verification for a processing time for which a TiN blanket film having a thickness of T nm is removed by etching. The following verification result evaluates the degree of improvement with respect to the etching rate in the etching removal of the blanket film. The same applies to other Comparative Examples and Examples in this point.

### <<Comparative Example 1 and Example 1>>

Etching solution 2 = SC1
EA = 20nm
Surrounding conditions in Verification experiment = In the atmosphere
Wavelength of Ultraviolet ray = 233 nm
Ultraviolet irradiation = No in Comparative Example 1, Done in Example 1
Distance DT = 5 mm
(= 4 mm from the substrate S to the liquid surface, 1 mm from the liquid surface to the ultraviolet ray generator 3)

FIG. 10 is a view schematically showing the respective etching results obtained by performing the etching processes of Comparative Example 1 and Example 1 on the substrate shown in FIG. 8, and in this figure, the field (a) shows the etching result in Comparative Example 1 and the field (b) shows the etching result in Example 1. As shown in this figure, no narrow space etching is performed in Comparative Example 1, and in Example 1, the narrow space etching is performed on the TiN film Ft having a narrow space size of 10 nm with the etching rate of 3.15 times that for etching removal of the TiN blanket film having a thickness of 20 nm. Further, no narrow space etching is performed on the TiN film Ft in narrower portions (2 nm and 4 nm).

### <Verification Experiment for The Third Embodiment>

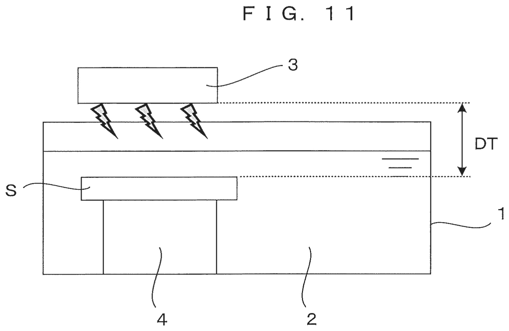

FIG. 11 is a view showing an overview of the verification experiment for the third embodiment. This verification experiment is different from that for the second embodiment (FIG. 9) in that the ultraviolet rays are irradiated toward the substrate S immersed in the etching solution 2 stored in the processing bath 1, and the experimental conditions other than the above are exactly the same as those in the second embodiment. Specifically, in Comparative Example 2 and Example 2, the type of the etching solution 2 which is used, EA, the surrounding conditions of the verification experiment, the wavelength of the ultraviolet ray, whether ultraviolet irradiation is performed or not, and the distance Dt between the substrate and the ultraviolet ray generator 3 in the up-and-down direction are as follows.

### <<Comparative Example 2 and Examples 2, 3, and 4>>

Etching solution 2 = SC1
EA = 20nm
Surrounding conditions in Verification experiment = In the atmosphere
Wavelength of Ultraviolet ray = 233 nm (Example 2), 237 nm (Example 3), 275 nm (Example 4)
Ultraviolet irradiation = No in Comparative Example 2, Done in Examples 2, 3, and 4
Distance DT = 5 mm
(= 4 mm from the substrate S to the liquid surface, 1 mm from the liquid surface to the ultraviolet ray generator 3)

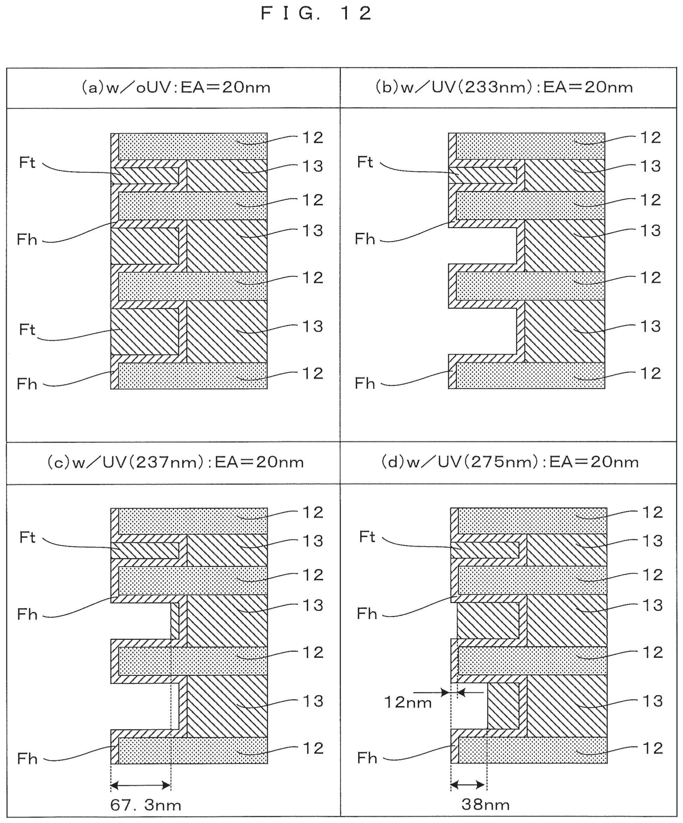

FIG. 12 is a view schematically showing the respective etching results obtained by performing the etching processes of Comparative Example 2 and Examples 2, 3, and 4 on the substrate shown in FIG. 8, and in this figure, the field (a) shows the etching result in Comparative Example 2, the field (b) shows the etching result in Example 2, the field (c) shows the etching result in Example 3, and the field (d) shows the etching result in Example 4. As shown in this figure, no narrow space etching is performed in Comparative Example 2 with no ultraviolet irradiation, and in each of Examples 2 and 3, the narrow space etching is performed on all the TiN film Ft having a narrow space size of 10 nm which fills the narrow region (with the etching rate of 3.79 times that for the TiN blanket film having a thickness of 20 nm) while the TiN blanket film having a thickness of 20 nm is removed by etching. Further, in a case where the ultraviolet ray having a wavelength of 233 nm is used, the narrow space etching is performed on all the TiN film Ft having a narrow space size of 4 nm which fills the narrow region, like the TiN film Ft having a narrow space size of 10 nm. Furthermore, in a case where the ultraviolet ray having a wavelength of 237 nm is used (Example 3), the narrow space etching is performed with the etching rate of 3.36 times that for the TiN blanket film having a thickness of 20 nm though slightly lower than that in the case where the ultraviolet ray having a wavelength of 233 nm is used. Further, in a case where the ultraviolet ray having a wavelength of 275 nm is used (Example 4), the narrow space etching is also performed on the TiN film Ft having a narrow space size of 10 nm or 4 nm though slightly lower than that in Examples 2 and 3. Furthermore, no narrow space etching is performed on the TiN film Ft having a narrow space size of 2 nm in any one of Examples 2 to 4.

From the comparison between Comparative Example 2 and Examples 2 and 3, it can be seen that it is more effective in increasing the efficiency of the narrow space etching to irradiate the substrate S together with the etching solution 2 with the ultraviolet rays than to irradiate the etching solution 2 with the ultraviolet rays to generate the OH radical. From the result of the verification experiment, it can be concluded that the third embodiment is more preferable than the second embodiment. Further, from the comparison among Examples 2, 3, and 4, it can be seen that the etching rate of the narrow space etching has wavelength dependence.

### <<Comparative Example 3 and Example 5>>

Etching solution 2 = SC2
EA = 20nm
Surrounding conditions in Verification experiment = In the atmosphere
Wavelength of Ultraviolet ray = 172 nm (Example 5)
Ultraviolet irradiation = No in Comparative Example 3, Done in Example 5
Distance DT = 5 mm
(= 4 mm from the substrate S to the liquid surface, 1 mm from the liquid surface to the ultraviolet ray generator 3)

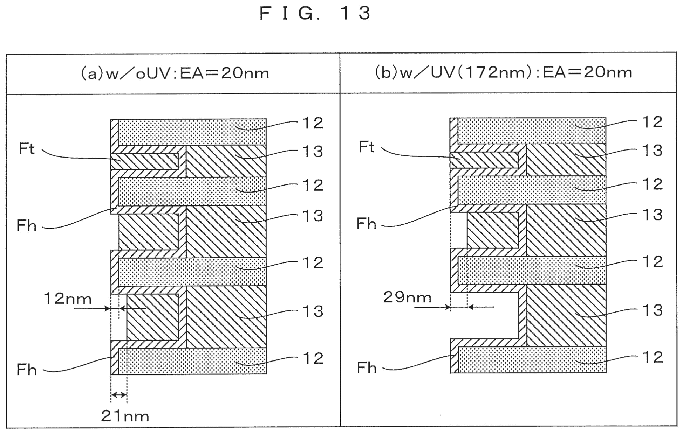

FIG. 13 is a view schematically showing the respective etching results obtained by performing the etching processes of Comparative Example 3 and Example 5 on the substrate shown in FIG. 8, and in this figure, the field (a) shows the etching result in Comparative Example 3 and the field (b) shows the etching result in Example 5. As shown in this figure, while the TiN blanket film having a thickness of 20 nm is removed by etching, in Comparative Example 3 with no ultraviolet irradiation, the narrow space etching is slightly performed on the TiN film Ft having a narrow space size of 10 nm or 4 nm, and on the other hand, in Example 5, the narrow space etching is performed on all the TiN film Ft having a narrow space size of 10 nm which fills the narrow region (with the etching rate of 3.79 times that for the TiN blanket film having a thickness of 20 nm). Further, the narrow space etching is performed on the TiN film Ft having a narrow space size of 4 nm only by 29 nm with the etching rate of 1.45 times that for the TiN blanket film having a thickness of 20 nm. Thus, even when the etching solution 2 is changed from SC1 to SC2, it is possible to etch the TiN film Ft which is the to-be-etched film with excellent etching rate.

### <<Comparative Example 4 and Examples 6 and 7>>

Etching solution 2 = dH₂O₂ (1:3)
EA = 10nm (Example 6), 20 nm (Example 7)
Surrounding conditions in Verification experiment = In the atmosphere
Wavelength of Ultraviolet ray = 172 nm (Examples 6 and 7)
Ultraviolet irradiation = No in Comparative Example 4, Done in Examples 6 and 7
Distance DT = 5 mm

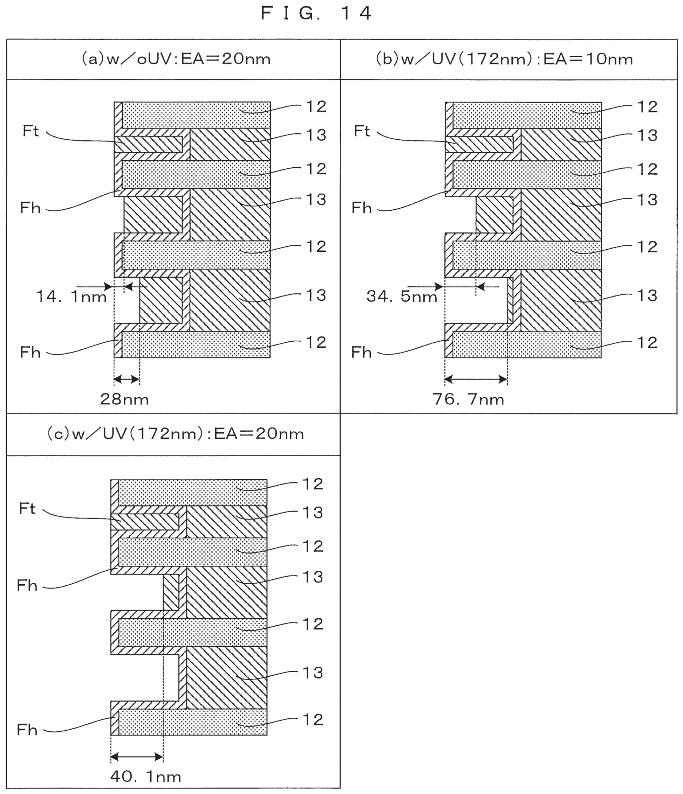

FIG. 14 is a view schematically showing the respective etching results obtained by performing the etching processes of Comparative Example 4 and Examples 6 and 7 on the substrate shown in FIG. 8, and in this figure, the field (a) shows the etching result in Comparative Example 4, the field (b) shows the etching result in Example 6, and the field (c) shows the etching result in Example 7. As shown in this figure, in Comparative Example 4 with no ultraviolet irradiation, while the TiN blanket film having a thickness of 20 nm is removed by etching, the narrow space etching is slightly performed on the TiN film Ft having a narrow space size of 10 nm or 4 nm only by 28 nm or 14.1 nm, respectively. On the other hand, in Example 6, while the TiN blanket film having a thickness of 10 nm is removed by etching, the narrow space etching is performed on the TiN film Ft having a narrow space size of 10 nm or 4 nm only by 76.7 nm or 34.5 nm, respectively (Example 6). Further, in Example 7, while the TiN blanket film having a thickness of 20 nm is removed by etching, the narrow space etching is performed on all the TiN film Ft having a narrow space size of 10 nm which fills the narrow region (with the etching rate of 3.79 times that for the TiN blanket film having a thickness of 20 nm). Furthermore, the narrow space etching is slightly performed on the TiN film Ft having a narrow space size of 4 nm only by 40.1 nm. As described above, even when the etching solution 2 is changed from SC1 or SC2 to dH₂O₂, it is possible to etch the TiN film Ft which is the to-be-etched film with excellent etching rate.

Although the invention has been described by way of the specific embodiments above, this description is not intended to be interpreted in a limited sense. By referring to the description of the invention, various modifications of the disclosed embodiments will become apparent to a person skilled in this art similarly to other embodiments of the invention. Hence, appended claims are thought to include these modifications and embodiments without departing from the true scope of the invention.

This invention can be applied to an etching technique in general for selectively etching a to-be-etched film by using an etching solution on a substrate on which the to-be-etched film is formed to be adjacent to an insulating film.

## Claims

1. An etching method comprising selectively etching a to-be-etched film by using an etching solution on a substrate on which the to-be-etched film is formed to be adjacent to an insulating film, wherein
the etching solution contains OH radical generated by irradiating the etching solution with ultraviolet rays.

2. The etching method according to claim 1, wherein
the etching includes supplying the etching solution containing the OH radical generated by irradiation of the ultraviolet rays to the substrate accommodated in a processing bath so as to selectively etch a to-be-etched film.

3. The etching method according to claim 2, wherein
the to-be-etched film is accommodated in the processing bath in a state where one main surface and the other main surface thereof are sandwiched between the insulating films, being in contact with the insulating films, and a side surface thereof is exposed, and
in the etching, the OH radical enters a narrow space sandwiched by the insulating films from side surface sides of the to-be-etched film so as to etch the to-be-etched film.

4. The etching method according to claim 1, wherein
the etching includes:
immersing the substrate into a processing bath in which the etching solution is stored; and
generating the OH radical by irradiation of the ultraviolet rays to the etching solution stored in the processing bath so as to etch the to-be-etched film with the OH radical.

5. The etching method according to claim 4, wherein
the to-be-etched film is immersed in the etching solution in the processing bath in a state where one main surface and the other main surface thereof are sandwiched between the insulating films, being in contact with the insulating films, and a side surface thereof is exposed, and
in the etching, the OH radical enters a narrow space sandwiched by the insulating films from side surface sides of the to-be-etched film so as to etch the to-be-etched film.

6. The etching method according to claim 4, wherein
the generating includes irradiating the insulating film with the ultraviolet rays together with the etching solution so as to additionally generate an etchant by photoelectrochemical reaction on the insulating film, the etchant additionally generated being different from the OH radical generated by irradiating the etching solution with the ultraviolet rays.

7. The etching method according to claim 6, wherein
the ultraviolet rays used in the additionally generating the etchant has a wavelength not longer than that corresponding to a bandgap of the insulating film.

8. The etching method according to claim 7, wherein
when the insulating film is HfO₂,
the ultraviolet rays used in the additionally generating the etchant has a wavelength not longer than 275 nm.

9. The etching method according to claim 2, wherein
the etching includes irradiating ultraviolet rays to the etching solution supplied to the substrate and the substrate so as to additionally generate the OH radical in the etching solution supplied to the substrate and an etchant by a photoelectrochemical reaction on the insulating film, the etchant additionally generated being different from the OH radical generated by irradiating the etching solution with the ultraviolet rays.

10. The etching method according to claim 9, wherein
the ultraviolet rays irradiating the etching solution supplied to the substrate and the substrate has a wavelength not longer than that corresponding to a bandgap of the insulating film.

11. The etching method according to claim 10, wherein
when the insulating film is HfO₂,
the ultraviolet rays irradiating the etching solution supplied to the substrate and the substrate has a wavelength not longer than 275 nm.

12. The etching method according to claim 1, wherein
the to-be-etched film is a blanket film formed on one main surface of the insulating film.

13. The etching method according to any one of claims 1 to 12, wherein
the etching solution is a solution containing one or more types selected from a group consisting of dH₂O₂, SC1, SC2, dHCl, dNH₄OH, dHF, DIW, and CO₂W.

14. The etching method according to any one of claims 1 to 13, wherein
the insulating film is formed of SiOₓ, HfOₓ, La₂O₃, TiCAL, ZrO, ScOₓ, or YO.

15. The etching method according to any one of claims 1 to 14, wherein
the to-be-etched film is formed of Al₂O₃, La₂O₃, W, Mo, Ru, or WDC.
